# EUROPÄISCHE PATENTSCHRIFT

(11) **EP 3 590 271 B1**
(45) Veröffentlichungstag und Bekanntmachung des Hinweises auf die Patenterteilung: **05.10.2022**
(21) Anmeldenummer: 18718817.2
(22) Anmeldetag: 19.04.2018
(51) Int. Cl.: H04R 1/24, H04R 9/06, H04R 23/02, H04R 17/00

(54) **LAUTSPRECHEREINHEIT MIT EINEM ELEKTRODYNAMISCHEN UND EINEM MEMS-LAUTSPRECHER**
LOUDSPEAKER UNIT COMPRISING AN ELECTRODYNAMIC LOUDSPEAKER AND A MEMS LOUDSPEAKER
UNITÉ HAUT-PARLEUR DOTÉE D'UN HAUT-PARLEUR ÉLECTRODYNAMIQUE ET D'UN HAUT-PARLEUR MEMS

(30) Priorität: 21.04.2017 DE 102017108594
(43) Veröffentlichungstag der Anmeldung: 08.01.2020
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT)
(74) Vertreter: Canzler & Bergmeier Patentanwälte Partnerschaft mbB
(86) Internationale Anmeldenummer: PCT/EP2018/060048
(87) Internationale Veröffentlichungsnummer: WO 2018/193038

(56) Entgegenhaltungen:
- DE-A1-102015 107 560
- JP-A- S6 194 499
- US-B1- 9 210 489

## Beschreibung

Die vorliegende Erfindung betrifft eine Lautsprechereinheit, insbesondere für ein tragbares Gerät und/oder zum Erzeugen von Schallwellen im hörbaren Wellenlängenspektrum, mit einem als Tieftonlautsprecher ausgebildeten elektrodynamischen Lautsprecher. Des Weiteren betrifft die Erfindung ein tragbares Gerät mit einer derartigen Lautsprechereinheit.

Aus der EP 1 271 999 A2 ist ein elektrodynamischer Lautsprecher für ein Mobilgerät bekannt. Um diesen möglichst klein ausbilden zu können, müssen in Bezug auf die akustische Leistungsfähigkeit des Lautsprechers Einbußen hingenommen werden. So kann mit einem derartigen Lautsprecher nicht die für ein hervorragendes Klangerlebnis notwendige akustische Bandbreite abgebildet werden. Andererseits würde ein entsprechend von der Leistungsfähigkeit optimierter Lautsprecher ein zu großes Bauvolumen einnehmen.

Aus der DE 10 2010 004 312 B4 ist ferner ein Lautsprecher zur aktiven Geräuschunterdrückung bekannt. Bei dem Lautsprecher handelt es sich ebenfalls um einen elektrodynamischen Lautsprecher. Um Umgebungsgeräusche erfassen zu können, umfasst der Lautsprecher ein MEMS-Mikrofon, das von einer Lautsprechermembran entkoppelt ist. Nachteilig hierbei ist, dass durch das MEMS-Mikrofon die Fläche der Membran des elektrodynamischen Lautsprechers reduziert wird. Hierdurch wird die ohnehin schon schlechte akustische Leistungsfähigkeit des Lautsprechers zusätzlich verschlechtert.

Aus der US 9,210,489 B1 ist ein Audio-Lautsprecher unter Verwendung einer einzelnen Audioquelle bekannt. Der Audio-Lautsprecher enthält eine integrierte Bass-Soundeinheit und eine integrierte Höhen-Soundeinheit. Beide weisen jeweils eine separate Membran auf.

Aus der JP S61 94499 A ist ein Lautsprecher mit einer scheibenförmigen ebenen Membran 39 bekannt, die mit einer Schwingspule über einen Kopplungskegel an der Unterseite der Membran verbunden ist. Im mittleren Teil der Oberseite der Membran ist ein Hochtonlautsprecher angeordnet, der aus einem ebenen piezoelektrischen Element besteht.

Aufgabe der vorliegenden Erfindung ist es somit, eine Lautsprechereinheit zu schaffen, die sich durch eine hohe akustische Leistungsfähigkeit und ein geringes Bauvolumen auszeichnet.

Die Aufgabe wird gelöst durch eine Lautsprechereinheit sowie ein tragbares Gerät mit einer derartigen Lautsprechereinheit mit den Merkmalen der unabhängigen Patentansprüche.

Vorgeschlagen wird eine Lautsprechereinheit, insbesondere für ein tragbares Gerät und/oder zum Erzeugen von Schallwellen im hörbaren Wellenlängenspektrum. Die Lautsprechereinheit ist insbesondere für ein Smartphone, ein Tablet, eine Smart Uhr, eine Smart Brille, eine Lautsprecherbox, ein Hörgerät und/oder einen Kopfhörer vorgesehen. Die Lautsprechereinheit umfasst einen als Tieftonlautsprecher ausgebildeten elektrodynamischen Lautsprecher. Der elektrodynamische Lautsprecher ist vorzugsweise derart ausgebildet, dass dieser für einen tiefen Frequenzbereich von vorzugsweise weniger als 2 kHz optimiert ist. Zusätzlich zum elektrodynamischen Lautsprecher umfasst die Lautsprechereinheit einen als Hochtonlautsprecher ausgebildeten MEMS-Lautsprecher. Der MEMS-Lautsprecher deckt somit eine im Vergleich zum elektrodynamischen Lautsprecher höheren Frequenzbereich ab. Die Frequenzbereiche des elektrodynamischen Lautsprechers und des MEMS-Lautsprechers können sich hierbei überlappen. Der MEMS-Lautsprecher ist vorzugsweise für einen Frequenzbereich von mehr als 2 kHz optimiert. Die Lautsprechereinheit weist somit vorzugsweise eine gesamte akustische Bandbreite von 200 Hz bis zu 30 kHz auf. Vorteilhafterweise kann der elektrodynamische Lautsprecher somit sehr kompakt ausgebildet werden, da dieser nur für die tiefen Frequenzen optimiert ausgelegt werden muss. Für die hohen Frequenzen wird der zusätzliche MEMS-Lautsprecher verwendet, der sich durch ein sehr kompaktes Bauvolumen auszeichnet. Infolgedessen kann eine Lautsprechereinheit geschaffen werden, die ein sehr geringes Bauvolumen aufweist. Zusätzlich zeichnet sich diese Lautsprechereinheit durch eine sehr gute Klangqualität aus, da sowohl die tiefen Frequenzen, insbesondere in einem Bereich von 200 Hz bis 2 kHz, durch den elektrodynamischen Lautsprecher und die hohen Frequenzen, insbesondere von 2 kHz bis 30 kHz, durch den MEMS-Lautsprecher abgedeckt werden. Die Lautsprechereinheit eignet sich somit insbesondere für den Einsatz in tragbaren Geräten, die möglichst kompakt und leicht ausgebildet sein müssen.

Der MEMS-Lautsprecher ist in den elektrodynamischen Lautsprecher integriert. Hierdurch kann die Lautsprechereinheit sehr kompakt ausgebildet werden. Des Weiteren bildet der MEMS-Lautsprecher zusammen mit dem elektrodynamischen Lautsprecher eine einteilige Baueinheit aus, die sehr einfach und somit kostengünstig und schnell in ein tragbares Gerät integriert werden kann.

Um die Lautsprechereinheit möglichst kompakt ausbilden zu können, teilen sich die beiden Lautsprecher, das heißt der MEMS-Lautsprecher und der elektrodynamische Lautsprecher, dieselbe Membran. Die Membran ist somit sowohl Bestandteil des elektrodynamischen Lautsprechers als auch des MEMS-Lautsprechers. Die Membran wird somit sowohl durch den elektrodynamischen Lautsprecher als auch durch den MEMS-Lautsprecher angesteuert. Hierbei kann die Membran von den beiden Lautsprechern im selben Bereich angesteuert werden. Alternativ können die Lautsprecher auch unterschiedliche Bereiche der Membran ansteuern. Die Ansteuerung der beiden Lautsprecher kann sequenziell erfolgen. Demnach kann die Membran in einem ersten Zeitfenster durch den elektrodynamischen Lautsprecher und in einem zweiten Zeitfenster durch den MEMS-Lautsprecher angesteuert werden. Alternativ ist es ebenso auch denkbar, dass die Membran zeitgleich vom elektrodynamischen Lautsprecher und vom MEMS-Lautsprecher angesteuert wird.

Vorteilhaft ist es, wenn der elektrodynamische Lautsprecher eine elektrodynamische erste Aktoreinheit aufweist. Vorzugsweise umfasst die erste Aktoreinheit einen Magneten. Der Magnet ist insbesondere ortsfest in der Lautsprechereinheit angeordnet. Des Weiteren bildet der Magnet vorzugsweise einen Polkern und/oder ein den Polkern umgebendes Ringelement aus. Bei dem Magneten handelt es sich vorzugsweise um einen Permanentmagneten. Zusätzlich oder alternativ umfasst die erste Aktoreinheit zumindest eine Polplatte. Die Polplatte ist vorzugsweise Plan und/oder U-förmig ausgebildet. In einer vorteilhaften Weiterbildung der Erfindung umfasst die erste Aktoreinheit eine erste Polplatte, die auf einer der Membran zugewandten Seite des Magneten angeordnet ist, und/oder eine zweite Polplatte, die vorzugsweise auf einer der membranabgewandten Seite des Magneten angeordnet ist. Die zweite Polplatte ist insbesondere U-förmig ausgebildet. Im Falle einer U-förmig ausgebildeten zweiten Polplatte weist die erste Aktoreinheit vorzugsweise kein Ringelement auf. Der Magnet bildet in diesem Fall insbesondere den Polkern. Zusätzlich oder alternativ umfasst die erste Aktoreinheit eine Schwingspule. Die Schwingspule ist, insbesondere gegenüber dem Magneten, entlang einer Membranauslenkachse bewegbar. Beim Bestromen der Schwingspule wird diese aufgrund einer hierduch erzeugten Corioliskraft entlang der Membranauslenkachse verschoben. Mit der elektrodynamischen ersten Aktoreinheit kann die Membran sehr gut zur Ausbildung des tiefen Frequenzbereiches der Lautsprechereinheit angesteuert werden.

In einer vorteilhaften Weiterbildung der Erfindung umfasst der MEMS-Lautsprecher eine piezoelektrische zweite Aktoreinheit. Die zweite Aktoreinheit umfasst vorzugsweise ein Trägersubstrat. Zusätzlich oder alternativ weist die zweite Aktoreinheit zumindest einen piezoelektrischen Aktor auf. Der piezoelektrische Aktor ist mit dem Trägersubstrat verbunden. Das Trägersubstrat dient somit zum Halten des piezoelektrischen Aktors an einem ihm zugewandten Ende. Zusätzlich oder alternativ weist der piezoelektrische Aktor ein gegenüber dem Trägersubstrat in Richtung der Membranauslenkachse auslenkbares freies Ende auf. Der piezoelektrische Aktor ist somit insbesondere als Kragarm ausgebildet. Mit seinem dem Trägersubstrat zugewandten Ende ist der piezoelektrische Aktor somit am Trägersubstrat verankert. Das abgewandte freie Ende des piezoelektrischen Aktors kann somit gegenüber dem Trägersubstrat in Richtung der Membranauslenkachse bewegt werden, wenn der piezoelektrische Aktor bestromt wird.

Vorteilhaft ist es, wenn die Membran in ihrem Randbereich in einem Lautsprechergehäuse aufgehängt ist. Das Lautsprechergehäuse ist hierbei vorzugsweise zumindest teilweise aus einem Kunststoff, insbesondere einem Kunststoffring, ausgebildet. Teile des Lautsprechergehäuses können insbesondere durch eine Leiterplatte und/oder eine Polplatte, insbesondere durch die zweite Polplatte, ausgebildet sein. In dem Lautsprechergehäuse ist die zweite Aktoreinheit und/oder zumindest die Schwingspule schützend aufgenommen.

Vorteilhaft ist es, wenn die Membran einen ersten Auslenkbereich aufweist. Der erste Auslenkbereich ist unmittelbar und/oder mittelbar derart mit der ersten und/oder zweiten Aktoreinheit gekoppelt, dass dieser von der ersten und/oder zweiten Aktoreinheit auslenkbar bzw. ansteuerbar ist. Der erste Auslenkbereich ist somit gegenüber dem Lautsprechergehäuse in Richtung der Membranauslenkachse auslenkbar.

Vorzugsweise ist die Membran aus einem elastischen Material, insbesondere Silikon, ausgebildet. Um eine Beschädigung der Membran vermeiden zu können, ist es vorteilhaft, wenn diese ein Versteifungselement, insbesondere eine Versteifungsplatte aufweist. Die Versteifungsplatte ist vorzugsweise im ersten Auslenkbereich angeordnet. Insbesondere erstreckt sich das Versteifungselement über zumindest einen Teil, vorzugsweise über den gesamten, ersten Auslenkbereich.

In einer vorteilhaften Weiterbildung der Erfindung ist die zweite Aktoreinheit mit der Schwingspule verbunden. Die Verbindung ist vorzugsweise derart ausgebildet, dass die zweite Aktoreinheit beim Ansteuern der Schwingspule gemeinsam mit der Schwingspule entlang der Membranauslenkachse bewegbar ist. Die zweite Aktoreinheit und die Schwingspule bilden somit eine gegenüber dem Magneten des elektrodynamischen Lautsprechers in Richtung der Membranauslenkachse bewegbare Einheit aus. Die zweite Aktoreinheit ist vorzugsweise im Bereich ihres Trägersubstrats mit der Schwingspule verbunden. Infolgedessen kann der zumindest eine piezoelektrische Aktor, insbesondere dessen freies Ende, gegenüber dem Trägersubstrat und der Schwingspule ausgelenkt werden.

Um die Lautsprechereinheit möglichst kompakt ausbilden zu können, ist es vorteilhaft, wenn die zweite Aktoreinheit, insbesondere in Bezug zur Membranauslenkachse, koaxial zur ersten Aktoreinheit angeordnet ist. Zusätzlich oder alternativ ist es diesbezüglich vorteilhaft, wenn in Bezug zur Membranauslenkachse die zweite Aktoreinheit zwischen der ersten Aktoreinheit und der Membran angeordnet ist. Die Schwingspule ist somit mittelbar über die zweite Aktoreinheit mit der Membran verbunden.

Vorteilhaft ist es, wenn der zumindest eine piezoelektrische Aktor in einem ersten Verbindungsbereich, insbesondere unmittelbar oder mittelbar, mit dem ersten Auslenkbereich verbunden ist. So kann der piezoelektrische Aktor, der vorzugsweise eine mehrschichtige piezoelektrische Struktur ist, unmittelbar, insbesondere vollflächig, mit der Membran im ersten Verbindungsbereich verbunden sein. Alternativ kann der piezoelektrische Aktor, der vorzugsweise eine mehrschichtige piezoelektrische Struktur ist, mittelbar mit der Membran im ersten Verbindungsbereich verbunden sein. In diesem Fall ist es vorteilhaft, wenn der zumindest eine piezoelektrische Aktor in Richtung der Membranauslenkachse von der Membran beabstandet ist. Zusätzlich oder alternativ ist der piezoelektrische Aktor im ersten Verbindungsbereich mit seinem freien Ende mittelbar über ein Koppelelement mit dem ersten Auslenkbereich der Membran verbunden. Das Koppelelement stellt somit einen Abstandshalter in Richtung der Membranauslenkachse zwischen dem piezoelektrischen Aktor und der Membran dar. Das Koppelement kann einteilig ausgebildet sein. In diesem Fall ist das Koppelelement herstellungsbedingt aus dem gleichen Material wie das Trägersubstrat ausgebildet. Des Weiteren weist das Trägersubstrat und das Koppelelement zueinander die gleiche Dicke in Richtung der Membranauslenkachse auf. Alternativ kann das Koppelelement aber auch mehrteilig ausgebildet sein. So kann ein Teil aus dem gleichen Material wie das Trägersubstrat ausgebildet sein und ein zweiter Teil kann auf dieses erste Teil aufgebracht, insbesondere aufgeklebt, sein. Das zweite Teil kann aus einem im Vergleich zum ersten Teil anderen Material, insbesondere einem Kunststoff ausgebildet sein.

In einer vorteilhaften Weiterbildung der Erfindung ist die Schwingspule mittelbar über den zumindest einen piezoelektrischen Aktor in dem ersten Verbindungsbereich mit dem ersten Auslenkbereich der Membran verbunden. Eine Auslenkbewegung der Schwingspule wird somit mittelbar über den zumindest einen piezoelektrischen Aktor an die Membran, insbesondere in ihrem ersten Auslenkbereich, übertragen. Über den zumindest einen piezoelektrischen Aktor ist die Schwingspule zusätzlich oder alternativ flexibel mit dem ersten Auslenkbereich der Membran verbunden.

Insbesondere wenn die Membran vollflächig von beiden Aktoreinheiten angesteuert werden soll, ist es vorteilhaft, wenn die Schwingspule ausschließlich mittelbar über den zumindest einen piezoelektrischen Aktor und/oder flexibel in dem ersten Verbindungsbereich mit dem ersten Auslenkbereich der Membran verbunden ist. "Ausschließlich" bedeutet, dass die erste Aktoreinheit somit ausschließlich mittelbar über die zweite Aktoreinheit die Membran ansteuern kann. Zwischen der ersten Aktoreinheit und der Membran besteht kein zusätzlicher Verbindungsbereich, über den die Membran unmittelbar angesteuert werden könnte. Vorteilhafterweise kann somit sowohl von der ersten als auch von der zweiten Aktoreinheit die Membran vollflächig genutzt werden.

Um die Membran in einer nicht ausgelenkten Neutrallage zentrieren zu können, ist es vorteilhaft, wenn die Lautsprechereinheit eine flexible Zentrierspinne aufweist. Vorzugsweise ist die Schwingspule und/oder die zweite Aktoreinheit mit der Zentrierspinne verbunden. Zusätzlich oder alternativ ist die Schwingspule und/oder die zweite Aktoreinheit mittels der Zentrierspinne gegenüber dem Lautsprechergehäuse in Richtung der Membranauslenkachse auslenkbar aufgehängt. Die Zentrierspinne ist vorzugsweise strom leitend ausgebildet, so dass die Schwingspule und/oder die zweite Aktoreinheit angesteuert werden können.

In einer vorteilhaften Weiterbildung der Erfindung ist die flexible Zentrierspinne durch eine flexible Leiterplatte ausgebildet. Die flexible Leiterplatte ist insbesondere aus einem flexiblen Polymer ausgebildet. Vorteilhaft ist es ferner, wenn die flexible Leiterplatte gewebte elastische Kontaktbahnen, insbesondere aus gewebten Kohlestofffasern oder gewebten Metallbahnen, umfasst. Des Weiteren ist es vorteilhaft, wenn die flexible Leiterplatte einen Kontaktbereich aufweist in dem die flexible Leiterplatte mit einer harten Leiterplatte, mit der Schwingspule und/oder mit dem zumindest einen piezoelektrischen Aktor elektrisch verbunden werden kann.

In einer vorteilhaften Weiterbildung der Erfindung weist die Membran einen zweiten Auslenkbereich auf. Der zweite Auslenkbereich ist ebenfalls gegenüber dem Lautsprechergehäuse in Richtung der Membranauslenkachse auslenkbar. Des Weiteren ist die Membran in ihrem zweiten Auslenkbereich derart, insbesondere mittelbar über das Trägersubstrat der zweiten Aktoreinheit, mit der ersten Aktoreinheit, insbesondere mit der Schwingspule, verbunden, dass der zweite Auslenkbereich von der ersten Aktoreinheit ansteuerbar ist.

Diesbezüglich ist es vorteilhaft, wenn die Schwingspule in einem zweiten Verbindungsbereich mit dem zweiten Auslenkbereich der Membran verbunden ist. Die Schwingspule ist vorzugsweise mittelbar über das Trägersubstrat der zweiten Aktoreinheit mit dem zweiten Auslenkbereich der Membran verbunden. Die Verbindung zwischen der Schwingspule und dem zweiten Auslenkbereich ist im zweiten Verbindungsbereich vorzugsweise starr ausgebildet. Infolgedessen wird eine Auslenkbewegung der Schwingspule unmittelbar, das heißt ohne ein dazwischengeschaltetes flexibles Element, an den zweiten Auslenkbereich der Membran übertragen. Die Schwingspule ist vorzugsweise zusätzlich zum ersten Verbindungsbereich, in der diese mittelbar über den zumindest einen flexiblen piezoelektrischen Aktor verbunden ist, auch im zweiten Verbindungsbereich mit dem zweiten Auslenkbereich der Membran verbunden. Wie bereits vorstehend erwähnt ist die Verbindung im zweiten Verbindungsbereich vorzugsweise starr ausgebildet, so dass die Bewegung der Schwingspule unmittelbar, das heißt ohne Bewegungsverfälschung, an den zweiten Auslenkbereich der Membran übertragen wird. Vorteilhafterweise kann somit der erste Auslenkbereich von der zweiten Aktoreinheit und der zweite Auslenkbereich von der ersten Aktoreinheit angesteuert werden.

Auch ist es vorteilhaft, wenn die Membran eine dem ersten Auslenkbereich zugeordnete, flexible erste Lautsprechersicke und/oder eine dem zweiten Auslenkbereich zugeordnete, flexible zweite Lautsprechersicke aufweist. Die erste Lautsprechersicke erlaubt es somit dem ersten Auslenkbereich in Richtung der Membranauslenkachse zu schwingen. Die zweite Lautsprechersicke ermöglicht es somit dem zweiten Auslenkbereich in Richtung der Membranauslenkachse zu schwingen. Infolgedessen weist die Membran zwei Auslenkbereiche auf, die von jeweils einer der beiden Aktoreinheiten angesteuert werden kann.

Diesbezüglich ist es insbesondere vorteilhaft, wenn der zweite Verbindungsbereich zwischen den beiden Lautsprechersicken angeordnet ist. Vorteilhafterweise umfasst der zweite Auslenkbereich somit den ersten Auslenkbereich, die erste Lautsprechersicke und/oder den zweiten Verbindungsbereich.

In einer nicht zur Erfindung gehörenden Ausführungsform ist der MEMS-Lautsprecher von dem elektrodynamischen Lautsprecher separiert. Sie befinden sich somit in keinem gemeinsamen Lautsprechergehäuse. Stattdessen stellen diese zwei separate Bauteile dar. Der MEMS-Lautsprecher und der davon separierte elektrodynamische Lautsprecher sind vorzugsweise separat voneinander in einem gemeinsamen Gehäuse angeordnet.

Bei der nicht zur Erfindung gehörenden Ausführungsform ist es vorteilhaft, wenn der MEMS-Lautsprecher und der von diesem separierte elektrodynamische Lautsprecher einen gemeinsamen oder jeweils einen separaten Resonanzhohlraum aufweisen. Zusätzlich oder alternativ ist es vorteilhaft, wenn diese einen gemeinsamen oder jeweils einen separaten Schallleithohlraum aufweisen. Im Falle eines gemeinsamen Schallleithohlraums ist es vorteilhaft, wenn der MEMS-Lautsprecher und der von diesem separierte elektrodynamische Lautsprecher eine gemeinsame Schallaustrittsöffnung aufweisen. Alternativ können diese aber auch jeweils eine separate Schallaustrittsöffnung aufweisen.

Vorgeschlagen wird ein tragbares Gerät mit einer Lautsprechereinheit. Das tragbare Gerät kann insbesondere ein Smartgerät, wie beispielsweise ein Smartphone, eine Smartuhr und/oder eine Smartbrille, ein Tablet, eine Lautsprecherbox, ein Hörgerät und/oder ein Kopfhörer sein. Die Lautsprechereinheit ist gemäß der vorangegangenen Beschreibung ausgebildet, wobei die genannten Merkmale einzeln oder in beliebiger Kombination vorhanden sein können. Hierdurch kann ein tragbares Gerät ausgebildet werden, dass eine sehr gute akustische Leistungsfähigkeit aufweist und zudem sehr leicht und kompakt ausgebildet sein kann.

Weitere Vorteile der Erfindung sind in den nachfolgenden Ausführungsbeispielen beschrieben. Es zeigt:
- **Figur 1a, 1b**: eine Lautsprechereinheit mit einem elektrodynamischen Lautsprecher und einem in den elektrodynamischen Lautsprecher integrierten MEMS-Lautsprecher gemäß einem ersten Ausführungsbeispiel,
- **Figur 2**: eine Schnittdarstellung einer Lautsprechereinheit mit einem elektrodynamischen Lautsprecher und einem darin integrierten MEMS-Lautsprecher gemäß einem zweiten Ausführungsbeispiel,
- **Figur 3**: eine Schnittdarstellung einer Lautsprechereinheit mit einem elektrodynamischen Lautsprecher und einem darin integrierten MEMS-Lautsprecher gemäß einem dritten Ausführungsbeispiel,
- **Figur 4a, 4b**: eine Lautsprechereinheit gemäß einer nicht zur Erfindung gehörenden Ausführungsform mit einem elektrodynamischen Lautsprecher und einem von diesem separierten MEMS-Lautsprecher gemäß einem ersten Ausführungsbeispiel und
- **Figur 5a, 5b**: eine Lautsprechereinheit gemäß einer nicht zur Erfindung gehörenden Ausführungsform mit einem elektrodynamischen Lautsprecher und einem von diesem separierten MEMS-Lautsprecher gemäß einem zweiten Ausführungsbeispiel.

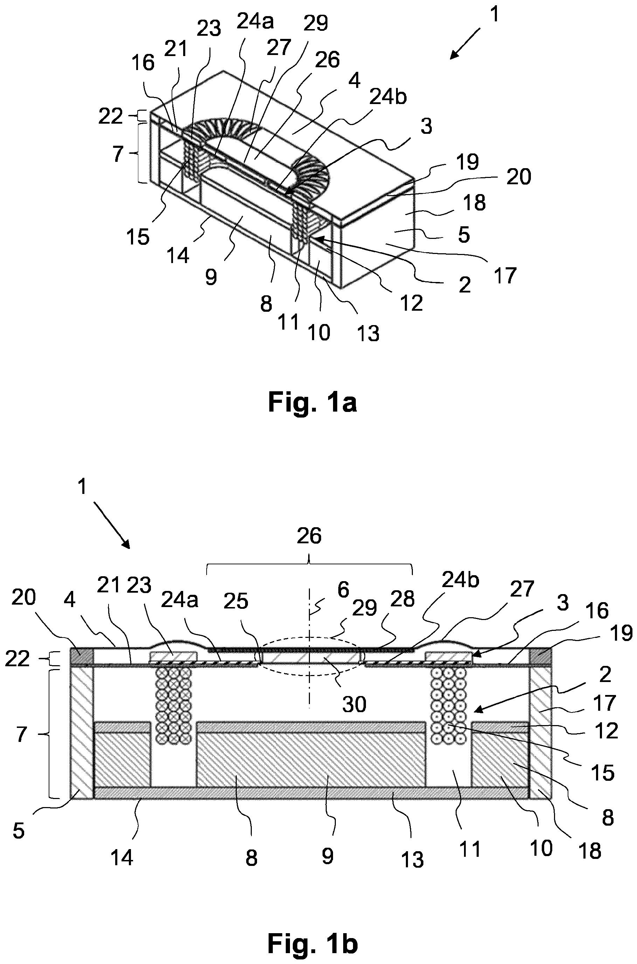

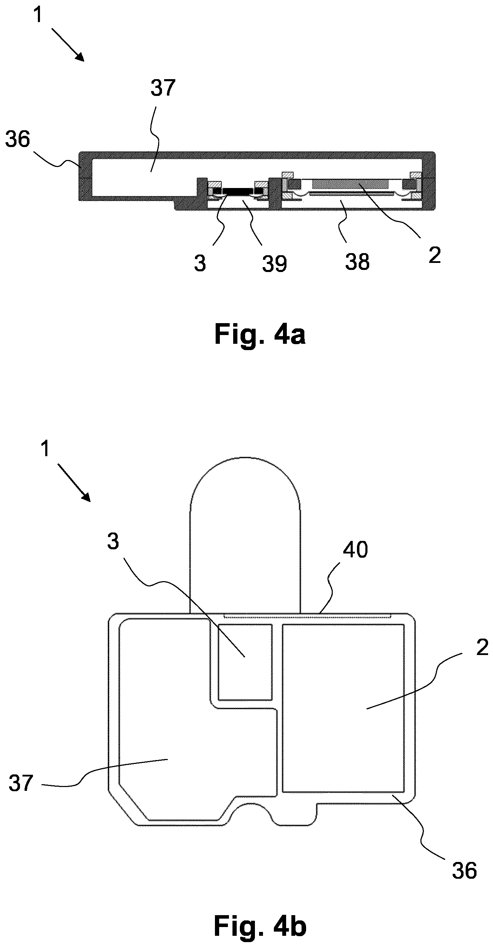

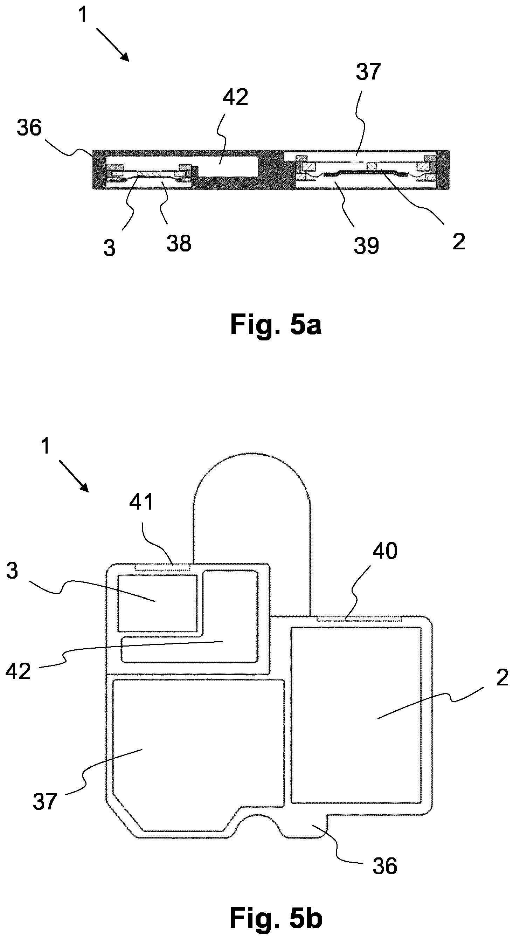

In den Figuren 1a, 1b, 2 und 3 sind unterschiedliche Ausführungsbeispiele einer Lautsprechereinheit 1 mit einem elektrodynamischen Lautsprecher 2 und einem in diesen integrierten MEMS-Lautsprecher 3 dargestellt. In den Figuren 4a, 4b, 5a und 5b sind zwei unterschiedliche Ausführungsbeispiele einer nicht zur Erfindung gehörenden Lautsprechereinheit 1 dargestellt, die ebenfalls einen elektrodynamischen Lautsprecher 2 und einen MEMS-Lautsprecher 3 umfassen, wobei diese im Gegensatz zu den in Figur 1a, 1b, 2 und 3 dargestellten Ausführungsbeispiel nicht integriert, sondern voneinander separiert sind. Der elektrodynamische Lautsprecher 2 ist bei den nachfolgend beschriebenen Ausführungsbeispielen vorzugsweise als Tieftonlautsprecher und der MEMS-Lautsprecher als Hochtonlautsprecher ausgebildet.

In Figur 1a und 1b ist ein erstes Ausführungsbeispiel einer Lautsprechereinheit 1 dargestellt, die einen elektrodynamischen Lautsprecher 2 und einen MEMS-Lautsprecher 3 umfasst. Der elektrodynamische Lautsprecher 2 und der MEMS-Lautsprecher 3 sind ineinander integriert. Der elektrodynamische Lautsprecher 2 ist als Tieftonlautsprecher ausgebildet. Infolgedessen deckt dieser insbesondere einen Frequenzbereich von 200 Hz bis 2 kHz ab. Der MEMS-Lautsprecher 2 ist als Hochtonlautsprecher ausgebildet. Er deckt demnach vorzugsweise einen Frequenzbereich von 2 kHz bis 30 kHz ab. Mit dem als Tieftonlautsprecher ausgebildeten elektrodynamischen Lautsprecher 2 und dem als Hochtonlautsprecher ausgebildeten MEMS-Lautsprecher 3 kann somit eine sehr kompakte Lautsprechereinheit 1 geschaffen werden, die ein breites Frequenzspektrum abdeckt und infolgedessen eine sehr hohe Klangqualität aufweist. Insbesondere aufgrund des für den Hochfrequenzbereich zuständigen MEMS-Lautsprechers 3 kann die Lautsprechereinheit 1 sehr kompakt und bauraumsparend ausgebildet werden. Auch bei den nachfolgenden Ausführungsbeispielen ist der jeweilige elektrodynamische Lautsprecher 2 als Tieftonlautsprecher und der MEMS-Lautsprecher 3 als Hochtonlautsprecher ausgebildet.

In dem in Figur 1a in einer perspektivischen Schnittansicht und in Figur 1b in einer Querschnittansicht dargestellten Ausführungsbeispiel umfasst die Lautsprechereinheit 1 eine Membran 4. Des Weiteren umfasst die Lautsprechereinheit 1 ein Lautsprechergehäuse 5. Die Membran 4 ist in ihrem Randbereich am Lautsprechergehäuse 5 befestigt bzw. in diesem aufgehängt. Die Membran 4 kann somit gemäß Figur 1b entlang einer Membranauslenkachse 6 ausgelenkt werden. Bei der vorliegenden integrativen Lautsprechereinheit 1 teilen sich die beiden Lautsprecher, d.h. der elektrodynamische Lautsprecher 2 und der MEMS-Lautsprecher 3, dieselbe Membran 4. Die Membran 4 ist somit sowohl Bestandteil des elektrodynamischen Lautsprechers 2 als auch des MEMS-Lautsprechers 3.

Wie insbesondere aus Figur 1b hervorgeht, umfasst der elektrodynamische Lautsprecher 2 eine erste Aktoreinheit 7. Diese erste Aktoreinheit 7 weist gemäß dem in Figur 1a und 1b dargestellten Ausführungsbeispiel einen Magneten 8 auf. Der Magnet 8 bildet einen Polkern 9 aus. Des Weiteren bildet der Magnet 8 ein Ringelement 10 aus. Das Ringelement 10 umgibt den Polkern 9. Außerdem umfasst die erste Aktoreinheit 7 einen Luftspalt 11. Vorliegend ist dieser Luftspalt 11 ringförmig ausgebildet. Der Luftspalt 11 befindet sich gemäß Figur 1b zwischen dem Polkern 9 und dem radial äußeren Ringelement 10. Auf seiner der Membran 4 zugewandten Seite weist der Magnet 8 eine erste Polplatte 12 auf. Auf seiner der Membran 4 abgewandten Seite weist der Magnet 8 eine zweite Polplatte 13 auf. Die erste Polplatte 12 ist plan ausgebildet. Des Weiteren ist die erste Polplatte 12 gemäß Figur 1b durch den Luftspalt 11 unterbrochen. Im Gegensatz dazu ist die zweite Polplatte 13 durchgängig ausgebildet. Des Weiteren bildet die zweite Polplatte 13 einen Gehäuseboden 14 des Lautsprechergehäuses 5 aus.

Wie aus Figur 1a und 1b hervorgeht, umfasst die erste Aktoreinheit 7 des Weiteren eine Schwingspule 15. Die Schwingspule 15 ist im Luftspalt 11 beweglich aufgehängt. Bei Bestromung der Schwingspule 15 wird diese in Abhängigkeit einer Corioliskraft in Richtung der Membranauslenkachse 6 bewegt.

Die Lautsprechereinheit 1 umfasst gemäß Figur 1b eine Zentrierspinne 16. Die Zentrierspinne 16 ist flexibel ausgebildet. In ihrem Randbereich ist die Zentrierspinne 16 am Lautsprechergehäuse 5 befestigt. Eine Seitenwandung 17 des Lautsprechergehäuses 5 ist vorliegend aus einem ersten und zweiten Gehäuseteil 18, 19 ausgebildet. Die Zentrierspinne 16 ist zwischen dem ersten und zweiten Gehäuseteil 18, 19 befestigt, insbesondere verklemmt und/oder verklebt. Das erste Gehäuseteil 18 ist vorzugsweise als Kunststoffteil ausgebildet. Das zweite Gehäuseteil 19 ist gemäß dem in Figur 1a und 1b dargestellten Ausführungsbeispiel eine harte Leiterplatte 20. Die Zentrierspinne 16 ist vorliegend als flexible Leiterplatte 21 ausgebildet. Die flexible Leiterplatte 21 kann somit entlang der Membranauslenkachse 6 ausgelenkt werden und dient dazu, die Membran 4 in einer nicht ausgelenkten Neutrallage zu zentrieren. Die flexible Leiterplatte 21 ist elektrisch leitend mit der harten Leiterplatte 20 verbunden.

Neben der ersten Aktoreinheit 7 umfasst die Lautsprechereinheit 1 eine zweite Aktoreinheit 22. Diese zweite Aktoreinheit 22 ist dem MEMS-Lautsprecher 3 zugeordnet. Die zweite Aktoreinheit 22 umfasst gemäß Figur 1b ein Trägersubstrat 23. Das Trägersubstrat ist vorzugsweise aus Silizium hergestellt. Des Weiteren umfasst die zweite Aktoreinheit 22 zumindest einen piezoelektrischen Aktor 24a, 24b. Hierbei handelt es sich vorzugsweise um eine mehrschichtige Aktorstruktur mit zumindest einer Elektrodenschicht und zumindest einer Piezoschicht. Der piezoelektrische Aktor 24a, 24b ist vorliegend als Kragarm ausgebildet. Infolgedessen ist der piezoelektrische Aktor 24a, 24b an seinem einen Ende mit dem Trägersubstrat 23 verbunden. Das Trägersubstrat 23 ist vorzugsweise als Rahmen ausgebildet. Des Weiteren weist der piezoelektrische Aktor 24a, 24b ein vom Trägersubstrat 23 abgewandtes freies Ende 25 auf. Bei elektrischer Ansteuerung des piezoelektrischen Aktors 24a, 24b kann dessen freies Ende 25 in Richtung der Membranauslenkachse 6 gegenüber dem Trägersubstrat 23 ausgelenkt werden. Gemäß dem in Figur 1a und 1b dargestellten Ausführungsbeispiel umfasst die zweite Aktoreinheit 22 zwei derartige piezoelektrische Aktoren 24a, 24b. Diese sind gegenüberliegend zueinander angeordnet.

Wie insbesondere aus Figur 1b hervorgeht, ist die Schwingspule 15 an der Zentrierspinne 16 befestigt bzw. über diese, entlang der Membranauslenkachse 6 auslenkbar, aufgehängt. Die Schwingspule 15 ist auf einer dem Magneten 8 zugewandten Seite der Zentrierspinne 16 befestigt. Des Weiteren ist die Schwingspule 15 über die Zentrierspinne 16, die wie vorstehend bereits erwähnt, als flexible Leiterplatte 21 ausgebildet ist, elektrisch mit der harten Leiterplatte 20 verbunden. Die harte Leiterplatte 20 umfasst vorzugsweise eine Steuerung, insbesondere einen ASIC.

Des Weiteren ist die zweite Aktoreinheit 22 mit der Zentrierspinne 16 verbunden und/oder von dieser getragen. Die zweite Aktoreinheit 22 ist gemäß dem vorliegenden Ausführungsbeispiel auf einer der Membran 4 zugewandten Seite der Zentrierspinne 16 angeordnet und mit dieser verbunden, insbesondere verklebt. Der piezoelektrische Aktor 24a, 24b ist über die als flexible Leiterplatte 21 ausgebildete Zentrierspinne 16 elektrisch leitend mit der harten Leiterplatte 20 verbunden. Infolgedessen kann sowohl der piezoelektrische Aktor 24a, 24b als auch die Schwingspule 15 über die flexible Leiterplatte 21 von einer vorliegend nicht dargestellten und vorzugsweise in der harten Leiterplatte 20 angeordneten Steuereinheit angesteuert werden.

Gemäß Figur 1a und 1b weist die Membran 4 einen ersten Auslenkbereich 26 auf. Diesem ersten Auslenkbereich 26 ist eine flexible erste Lautsprechersicke 27 zugeordnet. Die erste Lautsprechersicke 27 umgibt den ersten Auslenkbereich 26, so dass dieser entlang der Membranauslenkachse 6 ausgelenkt werden kann. Im ersten Auslenkbereich 26 weist die Membran 4 ein Versteifungselement 28 auf. Dieses ist an einer Innenseite bzw. einer der zweiten Aktoreinheit 22 zugewandten Seite der Membran 4 befestigt.

Wie insbesondere aus Figur 1b hervorgeht, umfasst die Lautsprechereinheit 1 einen ersten Verbindungsbereich 29, in dem die zweite Aktoreinheit 22 mit der Membran 4 gekoppelt ist. Vorliegend sind die piezoelektrischen Aktoren 24a, 24b im ersten Verbindungsbereich 29 mittelbar über ein Koppelelement 30 mit der Membran 4 verbunden. So sind die beiden piezoelektrischen Aktoren 24a, 24b im Bereich ihres jeweiligen freien Endes 25 mit dem Koppelelement 30 verbunden. Das Koppelelement 30 ist wiederum mit der Membran 4 im ersten Auslenkbereich 26, insbesondere an dem Versteifungselement 28, befestigt. Aufgrund des Koppelelements 30 sind die piezoelektrischen Aktoren 24a, 24b in Richtung der Membranauslenkachse 6 von der Membran 4 beabstandet. Das Koppelelement 30 ist gemäß dem vorliegenden Ausführungsbeispiel aus dem gleichen Material wie das Trägersubstrat 23 ausgebildet. Des Weiteren weist das Trägersubstrat 23 und das Koppelelement 30 fertigungsbedingt die gleiche Höhe auf.

Über den ersten Verbindungsbereich 29 kann die Membran 4 in ihrem ersten Auslenkbereich 26 somit von der piezoelektrischen zweiten Aktoreinheit 22 angesteuert werden. Zusätzlich kann die Membran 4 in ihrem ersten Auslenkbereich 26 gemäß dem vorliegenden Ausführungsbeispiel auch über die Schwingspule 15 angesteuert werden. Demnach wird eine Bewegung der Schwingspule 15 mittelbar über die piezoelektrischen Aktoren 24a, 24b und/oder über das Koppelelement 30 an die Membran 4 im ersten Auslenkbereich 26 übertragen. Im Bereich des Trägersubstrats 23 ist die zweite Aktoreinheit 22 von der Membran 4 entkoppelt. Beim Bewegen der Schwingspule 15 wird somit der erste Auslenkbereich 26 der Membran 4 ausgelenkt. Dieser durch die Schwingspule 15 eingebrachten Bewegung kann eine zweite Bewegung überlagert werden, die über den zumindest einen piezoelektrischen Aktor 24a, 24b an die Membran 4, nämlich an den ersten Auslenkbereich 26, übertragen wird.

Die zweite Aktoreinheit 22 ist, wie vorstehend erwähnt, im Bereich des Trägersubstrats 23 mit der Schwingspule gekoppelt. Infolgedessen wird bei einer Auslenkung der Schwingspule 15 auch die zweite Aktoreinheit 22 gemeinsam mit der Schwingspule 15 entlang der Membranauslenkachse 6 mitbewegt. Die Schwingspule 15 ist somit mittelbar über die zweite Aktoreinheit 22 mit dem ersten Auslenkbereich 26 der Membran 4 verbunden.

Um die Lautsprechereinheit 1 möglichst platzsparend ausbilden zu können ist die zweite Aktoreinheit 22 koaxial zur ersten Aktoreinheit 7 angeordnet. Des Weiteren befindet sich die zweite Aktoreinheit 22 in Bezug zur Membranauslenkachse 6 zwischen der ersten Aktoreinheit 7 und der Membran 4. Die zweite Aktoreinheit 22 ist somit der ersten Aktoreinheit 7 nachgeschalten. Infolgedessen resultiert bei aktiver ersten und aktiver zweiten Aktoreinheit 7, 22 eine überlagerte Gesamtbewegung des ersten Auslenkbereichs 26 der Membran 4, die sich aus einer durch die erste Aktoreinheit 7 verursachte erste Membranbewegung und einer durch die zweite Aktoreinheit 22 verursachte zweite Membranbewegung zusammensetzt.

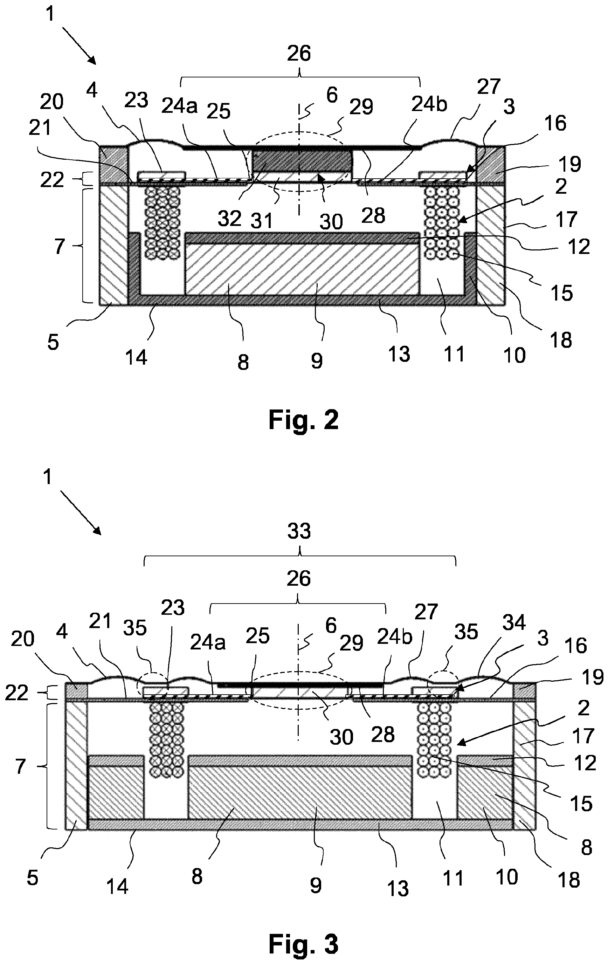

Bei der Beschreibung der in Figur 2 und 3 dargestellten Ausführungsbeispiele werden für Merkmale, die im Vergleich zu dem in Figur 1a und 1b dargestellten ersten Ausführungsbeispiel in ihrer Ausgestaltung und/oder Wirkweise identisch oder zumindest vergleichbar sind, gleiche Bezugszeichen verwendet. Sofern diese nicht nochmals detailliert erläutert werden, entspricht deren Ausgestaltung und Wirkweise derjenigen der vorstehend bereits beschriebenen Merkmale. Infolgedessen wird bei den in Figur 2 und 3 dargestellten Ausführungsbeispielen im Wesentlichen auf die Unterschiede eingegangen.

So ist bei dem in Figur 2 dargestellten Ausführungsbeispiel das Koppelelement mit einem ersten und zweiten Koppelteil 31, 32 mehrteilig ausgebildet. Das erste Koppelteil 31 ist hierbei aus dem gleichen Material wie das Trägersubstrat 23 ausgebildet. Das zweite Koppelteil 32 ist vorzugsweise aus einem dazu anderen Material, insbesondere einem Kunststoff, ausgebildet. Hierdurch kann der Abstand zwischen der Membran 4 und den piezoelektrischen Aktoren 24a, 24b in Richtung der Membranauslenkachse 6 vergrößert werden. Vorteilhafterweise kann die Membran 4 somit über einen größere Weglänge ausgelenkt werden.

Des Weiteren umfasst die erste Aktoreinheit 7 gemäß dem in Figur 2 dargestellten Ausführungsbeispiel kein durch den Magneten 8 ausgebildetes Ringelement 10. Der Magnet 8 bildet somit ausschließlich den Polkern 9 aus. Stattdessen ist die zweite Polplatte 13 U-förmig ausgebildet. Der Luftspalt 11 ist somit zwischen den U-Schenkeln der zweiten Polplatte 13 und dem Magneten 8 ausgebildet. Infolgedessen bilden die U-Schenkel der zweiten Polplatte 13 das Ringelement 10 aus.

Figur 3 zeigt ein drittes Ausführungsbeispiel der Lautsprechereinheit 1. Bei diesem ist die erste Aktoreinheit 7 wie bei dem in Figur 1a und 1b dargestellten ersten Ausführungsbeispiel ausgebildet. Alternativ könnte diese aber auch wie bei dem in Figur 2 dargestellten Ausführungsbeispiel ausgebildet sein. Gleiches trifft auf das Koppelelement 30 zu.

Im Unterschied zu dem in Figur 1a und 1b dargestellten Ausführungsbeispiel weist die Membran 4 bei dem in Figur 3 dargestellten Ausführungsbeispiel einen zweiten Auslenkbereich 33 auf. Dem zweiten Auslenkbereich 33 ist eine zweite Lautsprechersicke 34 zugeordnet. Die zweite Lautsprechersicke 34 umgibt den zweiten Auslenkbereich 33. Durch die flexible Ausbildung der zweiten Lautsprechersicke 34 kann der zweite Auslenkbereich 33 somit gegenüber dem Lautsprechergehäuse 5 entlang der Membranauslenkachse 6 ausgelenkt werden. Wie aus Figur 3 hervorgeht, ist der erste Auslenkbereich 26 innerhalb des zweiten Auslenkbereichs 33 angeordnet.

Neben dem ersten Verbindungsbereich 29 umfasst die Lautsprechereinheit 1 gemäß dem in Figur 3 dargestellten Ausführungsbeispiel einen zweiten Verbindungsbereich 35. Der zweite Verbindungsbereich 35 ist innerhalb des zweiten Auslenkbereiches 33 angeordnet und/oder als geschlossener Ring ausgebildet. In diesem zweiten Verbindungsbereich 35 ist die Schwingspule 15 mit dem zweiten Auslenkbereich 33 der Membran 4 verbunden. Die Verbindung zwischen Schwingspule 15 und zweitem Auslenkbereich 33 erfolgt hierbei mittelbar über das dazwischen angeordnete Trägersubstrat 23. So ist die Membran 4 auf ihrer Unterseite bzw. auf ihrer dem Trägersubstrat 23 zugewandten Seite am Trägersubstrat 23 im zweiten Verbindungsbereich 35 befestigt, insbesondere verklebt.

Der zweite Auslenkbereich 33 umfasst somit von innen nach außen gesehen den ersten Auslenkbereich 26, die erste Lautsprechersicke 27 und/oder den zweiten Verbindungsbereich 35. Beim Ansteuern der Schwingspule 15 wird somit die Schwingspulenbewegung über den zweiten Verbindungsbereich 35 an die Membran 4 übertragen, so dass der zweite Auslenkbereich 35, der sich innerhalb der zweiten Lautsprechersicke 34 befindet, entlang der Membranauslenkachse 6 ausgelenkt wird.

Der sich innerhalb der ersten Lautsprechersicke 27 befindliche erste Auslenkbereich 26 kann nunmehr zusätzlich über den zumindest einen piezoelektrischen Aktor 24a, 24b ausgelenkt werden. Die Auslenkbewegung der Schwingspule 15 und die Auslenkbewegung des zumindest einen piezoelektrischen Aktors 24a, 24b sind somit voneinander entkoppelt bzw. zwei unterschiedlichen Auslenkbereichen 26, 33 zugeordnet.

Gemäß Figur 3 ist die Schwingspule 15 und die zweite Aktoreinheit 22 von der Seitenwandung 17 beabstandet. Dieser Abstand entspricht vorzugsweise der Breite der zweiten Lautsprechersicke 34.

In Figur 4a und 4b ist ein nicht zur Erfindung gehörendes Ausführungsbeispiel der Lautsprechereinheit 1 dargestellt, bei der der MEMS-Lautsprecher 3 von dem elektrodynamischen Lautsprecher 2 separiert ist. Figur 4a zeigt eine Querschnittsansicht der Lautsprechereinheit 1. Figur 4b zeigt eine Draufsicht der Lautsprechereinheit 1. Der MEMS-Lautsprecher 3 und der elektrodynamische Lautsprecher 2 sind in einem Gehäuse 36 separiert voneinander angeordnet. Wie insbesondere aus Figur 4a hervorgeht, weist das Gehäuse 36 einen Resonanzhohlraum 37 auf. Hierbei handelt es sich um einen gemeinsamen Resonanzhohlraum 37, den sich der elektrodynamische Lautsprecher 2 und der MEMS-Lautsprecher 3 teilen. Des Weiteren weist der elektrodynamische Lautsprecher 2 einen ersten Schallleithohlraum 38 und der MEMS-Lautsprecher 3 einen zweiten Schallleithohlraum 39 auf. Die beiden Schallleithohlräume 38, 39 vereinen sich zu einem gemeinsamen Schallleithohlraum. Infolgedessen weisen diese gemäß Figur 4b eine gemeinsame Schallaustrittsöffnung 40 auf. Alternativ können diese aber auch zwei voneinander separierte Schallaustrittsöffnungen aufweisen.

In dem in Figur 5a und 5b dargestellten Ausführungsbeispiel ist ebenfalls eine nicht zur Erfindung gehörende Lautsprechereinheit 1 dargestellt, die einen elektrodynamischen Lautsprecher 2 und einen von diesem separierten MEMS-Lautsprecher 3 umfasst. Im Gegensatz zu dem in Figur 4a und 4b dargestellten Ausführungsbeispiel umfasst der elektrodynamische Lautsprecher 2 einen ersten Resonanzhohlraum 37 und der MEMS-Lautsprecher 3 einen von diesem separierten zweiten Resonanzhohlraum 42. Des Weiteren weisen diese jeweils einen Schallleithohlraum 38, 39 auf, die voneinander separiert sind. Jedem dieser Schallleithohlraum 38, 39 ist somit gemäß Figur 5b eine separate Schallaustrittsöffnung 40, 41 zugeordnet.

In einem vorliegend nicht dargestellten zur Erfindung gehörenden Ausführungsbeispiel kann zumindest einer der in den Ausführungsbeispielen gemäß Figur 4a, 4b und/oder 5a, 5b dargestellten Lautsprecher, d.h. der elektrodynamische Lautsprecher 2 und/oder der von diesem separierte MEMS-Lautsprecher 3, gemäß einem in Figur 1a, 1b, 2 und/oder 3 dargestellten Ausführungsbeispielen ausgebildet sein. Infolgedessen kann der erste Lautsprecher 2 und/oder der zweite Lautsprecher 3 in den in Figur 4a, 4b und/oder 5a, 5b dargestellten Ausführungsbeispielen als in Figur 1a, 1b, 2 und/oder 3 dargestellte Lautsprechereinheit 1, d.h. als Integrallautsprecher mit elektrodynamischen Lautsprecher 2 und darin integriertem MEMS-Lautsprecher 3, ausgebildet sein.

Die vorstehend beschriebenen Lautsprechereinheiten 1 sind für tragbare Geräte, wie beispielsweise Mobiltelefone, Tabletts, Smartphones, Smartbrillen, Lautsprecherboxen, Hörgeräte und/oder Kopfhörer, vorgesehen.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Lautsprechereinheit
- 2: elektrodynamischer Lautsprecher
- 3: MEMS-Lautsprecher
- 4: Membran
- 5: Lautsprechergehäuse
- 6: Membranauslenkachse
- 7: erste Aktoreinheit
- 8: Magnet
- 9: Polkern
- 10: Ringelement
- 11: Luftspalt
- 12: erste Polplatte
- 13: zweite Polplatte
- 14: Gehäuseboden
- 15: Schwingspule
- 16: Zentrierspinne
- 17: Seitenwandung
- 18: erstes Gehäuseteil
- 19: zweites Gehäuseteil
- 20: harte Leiterplatte
- 21: flexible Leiterplatte
- 22: zweite Aktoreinheit
- 23: Trägersubstrat
- 24: piezoelektrischer Aktor
- 25: freies Ende
- 26: erster Auslenkbereich
- 27: erste Lautsprechersicke
- 28: Versteifungselement
- 29: erster Verbindungsbereich
- 30: Koppelelement
- 31: erstes Koppelteil
- 32: zweites Koppelteil
- 33: zweiter Auslenkbereich
- 34: zweite Lautsprechersicke
- 35: zweiter Verbindungsbereich
- 36: Gehäuse
- 37: erster Resonanzhohlraum
- 38: erster Schallleithohlraum
- 39: zweiter Schallleithohlraum
- 40: erste Schallaustrittsöffnung
- 41: zweite Schallaustrittsöffnung
- 42: zweiter Resonanzhohlraum

## Patentansprüche

1. Lautsprechereinheit (1)
mit einem als Tieftonlautsprecher ausgebildeten elektrodynamischen Lautsprecher (2) und
einem als Hochtonlautsprecher ausgebildeten MEMS-Lautsprecher (3),
der in den elektrodynamischen Lautsprecher (2) integriert ist
**dadurch gekennzeichnet,**
**dass** sich die beiden Lautsprecher (2, 3) dieselbe Membran (4) teilen, so dass die Membran (4) sowohl durch den elektrodynamischen Lautsprecher (2) als auch durch den MEMS-Lautsprecher (3) ansteuerbar ist.

2. Lautsprechereinheit nach dem vorherigen Anspruch, **dadurch gekennzeichnet, dass** der elektrodynamische Lautsprecher (2) eine elektrodynamische erste Aktoreinheit (7) mit einem Magneten (8) und einer entlang einer Membranauslenkachse (6) bewegbaren Schwingspule (15) umfasst und/oder
dass der MEMS-Lautsprecher (3) eine piezoelektrische zweite Aktoreinheit (22) mit einem Trägersubstrat und zumindest einem piezoelektrischen Aktor (24a, 24b), der mit dem Trägersubstrat verbunden ist und ein gegenüber dem Trägersubstrat in Richtung der Membranauslenkachse (6) auslenkbares freies Ende (25) aufweist, umfasst.

3. Lautsprechereinheit nach dem vorherigen Anspruch 2, **dadurch gekennzeichnet, dass** die Membran (4) in ihrem Randbereich in einem Lautsprechergehäuse (5) aufgehängt ist,
dass die Membran (4) einen gegenüber dem Lautsprechergehäuse (5) in Richtung der Membranauslenkachse (6) von der ersten und zweiten Aktoreinheit (7, 22) auslenkbaren ersten Auslenkbereich (26) aufweist und
dass der zumindest eine piezoelektrische Aktor (24a, 24b) in einem ersten Verbindungsbereich (29) unmittelbar oder mittelbar mit dem ersten Auslenkbereich (26) verbunden ist.

4. Lautsprechereinheit nach einem der vorherigen Ansprüche 2 bis 3, **dadurch gekennzeichnet, dass** die zweite Aktoreinheit (22) mit der Schwingspule (15) verbunden ist, so dass die zweite Aktoreinheit (22) beim Ansteuern der Schwingspule (15) gemeinsam mit dieser entlang der Membranauslenkachse (6) bewegbar ist.

5. Lautsprechereinheit nach einem der vorherigen Ansprüche 2 bis 4, **dadurch gekennzeichnet, dass** die zweite Aktoreinheit (22) in Bezug zur Membranauslenkachse (6) zwischen der ersten Aktoreinheit (7) und der Membran (4) angeordnet ist.

6. Lautsprechereinheit nach einem der vorherigen Ansprüche 2 bis 5, **dadurch gekennzeichnet, dass** der zumindest eine piezoelektrische Aktor (24a, 24b) in Richtung der Membranauslenkachse (6) von der Membran (4) beabstandet ist und
im ersten Verbindungsbereich (29) mit seinem freien Ende (25) mittelbar über ein Koppelelement (30) mit dem ersten Auslenkbereich (26) verbunden ist.

7. Lautsprechereinheit nach einem der vorherigen Ansprüche 3 bis 6, **dadurch gekennzeichnet, dass** die Schwingspule (15) mittelbar über den zumindest einen piezoelektrischen Aktor (24a, 24b) und flexibel in dem ersten Verbindungsbereich (29) mit dem ersten Auslenkbereich (26) der Membran (4) verbunden ist.

8. Lautsprechereinheit nach einem der vorherigen Ansprüche 3 bis 7, **dadurch gekennzeichnet, dass** die Lautsprechereinheit (1) eine als flexible Leiterplatte (21) ausgebildete flexible Zentrierspinne (16) aufweist, mit der die Schwingspule (15) und die zweite Aktoreinheit (22) verbunden und gegenüber dem Lautsprechergehäuse (5) in Richtung der Membranauslenkachse (6) auslenkbar aufgehängt sind.

9. Lautsprechereinheit nach einem der vorherigen Ansprüche 3 bis 8, **dadurch gekennzeichnet, dass** die Membran (4) einen gegenüber dem Lautsprechergehäuse (5) in Richtung der Membranauslenkachse (6) von der ersten Aktoreinheit (7) auslenkbaren zweiten Auslenkbereich (33) aufweist und
dass die Schwingspule (15) in einem zweiten Verbindungsbereich (35) mit dem zweiten Auslenkbereich (33) der Membran (4) verbunden ist.

10. Lautsprechereinheit nach dem vorherigen Anspruch 9, **dadurch gekennzeichnet, dass** die Membran (4) eine dem ersten Auslenkbereich (26) zugeordnete, flexible erste Lautsprechersicke (27) und eine dem zweiten Auslenkbereich (33) zugeordnete, flexible zweite Lautsprechersicke (34) aufweist und
dass der zweite Verbindungsbereich (35) zwischen den beiden Lautsprechersicken (27, 34) angeordnet ist.

11. Tragbares Gerät mit einer Lautsprechereinheit (1), **dadurch gekennzeichnet, dass** die Lautsprechereinheit (1) nach einem oder mehreren der vorherigen Ansprüche ausgebildet ist.

## Claims

1. The loudspeaker unit (1)
comprising an electrodynamic loudspeaker (2) designed as a woofer and
a MEMS loudspeaker (3) designed as a tweeter,
been integrated into the electrodynamic loudspeaker (2)
**characterized in that**
the two loudspeakers (2, 3) share the same diaphragm (4),
such that the diaphragm (4) can be actuated by both the electrodynamic loudspeaker (2) and the MEMS loudspeaker (3).

2. The loudspeaker unit as claimed in the preceding claim **characterized in that** the electrodynamic loudspeaker (2) comprises an electrodynamic first actuator unit (7), including a magnet (8) and a moving coil (15) deflectable along a diaphragm deflection axis (6), and/or
the MEMS loudspeaker (3) comprises a piezoelectric second actuator unit (22), including a support substrate and at least one piezoelectric actuator (24a, 24b), which is connected to the support substrate and includes a free end (25) deflectable with respect to the support substrate in the direction of the diaphragm deflection axis (6).

3. The loudspeaker unit as claimed in the preceding claim 2, **characterized in that** the diaphragm (4) is suspended, in its edge region, in a loudspeaker housing (5),
the diaphragm (4) comprises a first deflection region (26) deflectable by the first actuator unit (7) and/or the second actuator unit (22) with respect to the loudspeaker housing (5) in the direction of the diaphragm deflection axis (6), and
the at least one piezoelectric actuator (24a, 24b) is connected, in a first connection region (29), directly or indirectly to the first deflection region (26).

4. The loudspeaker unit as claimed in one of the preceding claims 2 to 3, **characterized in that** the second actuator unit (22) is connected to the moving coil (15), so that, upon activation of the moving coil (15), the second actuator unit (22) is movable together with the moving coil (15) along the diaphragm deflection axis (6).

5. The loudspeaker unit as claimed in one of the preceding claims 2 to 4, **characterized in that** the second actuator unit (22) is arranged between the first actuator unit (7) and the diaphragm (4) with respect to the diaphragm deflection axis (6).

6. The loudspeaker unit as claimed in one of the preceding claims 2 to 5, **characterized in that** the at least one piezoelectric actuator (24a, 24b) is spaced apart from the diaphragm (4) in the direction of the diaphragm deflection axis (6), and
is connected, in the first connection region (29), via its free end (25) indirectly to the first deflection region (26) via a coupling element (30).

7. The loudspeaker unit as claimed in one of the preceding claims 3 to 6, **characterized in that** the moving coil (15) is connected indirectly via the at least one piezoelectric actuator (24a, 24b) and flexibly in the first connection region (29) to the first deflection region (26) of the diaphragm (4).

8. The loudspeaker unit as claimed in one of the preceding claims 3 to 7, **characterized in that** the loudspeaker unit (1) comprises a flexible centering spider (16), designed as a flexible circuit board (21), to which the moving coil (15) and the second actuator unit (22) are connected and are suspended so as to be deflectable with respect to the loudspeaker housing (5) in the direction of the diaphragm deflection axis (6).

9. The loudspeaker unit as claimed in one of the preceding claims 3 to 8, **characterized in that** the diaphragm (4) comprises a second deflection region (33) deflectable by the first actuator unit (7) with respect to the loudspeaker housing (5) in the direction of the diaphragm deflection axis (6), and
the moving coil (15) is connected, in a second connection region (35), to the second deflection region (33) of the diaphragm (4).

10. The loudspeaker unit as claimed in the preceding claim 9, **characterized in that** the diaphragm (4) comprises a flexible first loudspeaker corrugation (27) associated with the first deflection region (26) and a flexible second loudspeaker corrugation (34) associated with the second deflection region (33), and
the second connection region (35) is arranged between the two loudspeaker corrugations (27, 34).

11. A portable device comprising a loudspeaker unit (1), **characterized in that** the loudspeaker unit (1) is designed as claimed in one or more of the preceding claims.

## Revendications

1. Unité de haut-parleur (1)
avec un haut-parleur électrodynamique (2) conçu en tant que haut-parleur de graves et
un haut-parleur MEMS (3) conçu en tant que haut-parleur d'aiguës, qui est intégré dans le haut-parleur électrodynamique (2),
**caractérisée en ce que**
les deux haut-parleurs (2, 3) se partagent la même membrane (4), de sorte que la membrane (4) peut être commandée à la fois par le haut-parleur électrodynamique (2) et par le haut-parleur MEMS (3).

2. Unité de haut-parleur selon la revendication précédente, **caractérisée en ce que** le haut-parleur électrodynamique (2) comprend une première unité d'actionneur électrodynamique (7) avec un aimant (8) et une bobine acoustique (15) pouvant se déplacer le long d'un axe de déviation (6) de membrane, et/ou
**en ce que** le haut-parleur MEMS (3) comprend une deuxième unité d'actionneur piézoélectrique (22) avec un substrat support et au moins un actionneur piézoélectrique (24a, 24b) qui est relié au substrat support et qui présente une extrémité libre (25) pouvant être déviée par rapport au substrat support dans la direction de l'axe de déviation (6) de la membrane.

3. Unité de haut-parleur selon la revendication 2 précédente, **caractérisée en ce que** la membrane (4) est suspendue dans sa zone de bordure dans une enceinte de haut-parleur (5),
**en ce que** la membrane (4) présente une première zone de déviation (26) pouvant être déviée par rapport à l'enceinte de haut-parleur (5) en direction de l'axe de déviation (6) de la membrane par la première et la deuxième unités d'actionneur (7, 22) et
**en ce que** l'au moins un actionneur piézoélectrique (24a, 24b) est relié directement ou indirectement à la première zone de déviation (26) dans une première zone de connexion (29).

4. Unité de haut-parleur selon l'une quelconque des revendications 2 à 3 précédentes, **caractérisée en ce que** la deuxième unité d'actionneur (22) est reliée à la bobine acoustique (15), de sorte que la deuxième unité d'actionneur (22), lors de la commande de la bobine acoustique (15), peut être déplacée le long de l'axe de déviation (6) de la membrane conjointement avec la bobine acoustique.

5. Unité de haut-parleur selon l'une quelconque des revendications 2 à 4 précédentes, **caractérisée en ce que** la deuxième unité d'actionneur (22) est disposée entre la première unité d'actionneur (7) et la membrane (4) par rapport à l'axe de déviation (6) de la membrane.

6. Unité de haut-parleur selon l'une quelconque des revendications 2 à 5 précédentes, **caractérisée en ce que** l'au moins un actionneur piézoélectrique (24a, 24b) est espacé de la membrane (4) dans la direction de l'axe de déviation (6) de la membrane, et
est, dans la première zone de connexion (29), relié indirectement, par son extrémité libre (25), à la première zone de déviation (26) par un élément de couplage (30).

7. Unité de haut-parleur selon l'une quelconque des revendications 3 à 6 précédentes, **caractérisée en ce que** la bobine acoustique (15) est reliée indirectement à la première zone de déviation (26) de la membrane (4) par l'intermédiaire de l'au moins un actionneur piézoélectrique (24a, 24b) et de manière souple dans la première zone de connexion (29).

8. Unité de haut-parleur selon l'une quelconque des revendications 3 à 7 précédentes, **caractérisée en ce que** l'unité de haut-parleur (1) présente un croisillon de centrage (16) souple conçu en tant que carte imprimée souple (21), avec lequel la bobine acoustique (15) et la deuxième unité d'actionneur (22) sont reliées et suspendues de manière à pouvoir être déviées par rapport à l'enceinte de haut-parleur (5), dans la direction de l'axe de déviation (6) de la membrane.

9. Unité de haut-parleur selon l'une quelconque des revendications 3 à 8 précédentes, **caractérisée en ce que** la membrane (4) présente une deuxième zone de déviation (33) pouvant être déviée par rapport à l'enceinte de haut-parleur (5) en direction de l'axe de déviation (6) de la membrane par la première unité d'actionneur (7) et
**en ce que** la bobine acoustique (15) est reliée dans une deuxième zone de connexion (35) à la deuxième zone de déviation (33) de la membrane (4).

10. Unité de haut-parleur selon la revendication 9 précédente, **caractérisée en ce que** la membrane (4) présente une première moulure de haut-parleur (27) souple associée à la première zone de déviation (26) et une deuxième moulure de haut-parleur (34) souple associée à la deuxième zone de déviation (33), et
**en ce que** la deuxième zone de connexion (35) est disposée entre les deux moulures de haut-parleur (27, 34).

11. Appareil portatif avec une unité de haut-parleur (1), **caractérisé en ce que** l'unité de haut-parleur (1) se présente sous une forme selon l'une quelconque ou plusieurs des revendications précédentes.
